# EUROPÄISCHE PATENTANMELDUNG

(11) **EP 0 893 829 A1**
(43) Veröffentlichungstag der Anmeldung: **27.01.1999**
(21) Anmeldenummer: 98113603.9
(22) Anmeldetag: 21.07.1998
(51) Int. Cl.: H01L 29/10, H01L 27/02

(54) **MOS-Ausgangstreiber**

(30) Priorität: 25.07.1997 DE 19732179
(71) Anmelder: SIEMENS AKTIENGESELLSCHAFT, 80333 München (DE)
(72) Erfinder: Schneider, Helmut, 80993 München (DE); Buck, Martin, 81243 München (DE)

(57) **Zusammenfassung**

Die Erfindung betrifft einen MOS-Ausgangstreiber mit in ein Halbleitersubstrat (9) eingebetteten Source- und Drainzonen (1, 2) des einen Leitfähigkeitstyps, die in einer Wanne (3) des anderen Leitfähigkeitstyps voneinander beabstandet sind. Die Wanne (3) ist von einer Abschirmschicht (5) des einen Leitfähigkeitstyps umgeben.

## Beschreibung

Die Erfindung betrifft einen MOS-Ausgangstreiber mit in ein Halbleitersubstrat eingebetteten Source- und Drainzonen des einen Leitfähigkeitstyps, die in einer Wanne des anderen, zum einen Leitfähigkeitstyp entgegengesetzten Leitfähigkeitstyps voneinander beabstandet sind.

Bei MOS-Ausgangstreibern treten starke Kopplungen von deren Ausgangssignalen und dem Substrat und auch von deren Versorgungsspannungen mit anderen Versorgungsspannungen benachbarter Bauelemente auf, was Rauschprobleme verursacht. So besteht eine Kopplung von Diffusionsgebieten, wie Source- und Drainzone, in das Substrat. Steigt beispielsweise die Spannung am Ausgangsanschluß an, so wird auch das Substrat "hochgezogen". Da aber das Substrat häufig mit dem Masse-Netz auf dem Chip verbunden ist, übertragen sich die Spannungsschwankungen im Substrat sofort auf Potentialschwankungen des Masse-Netzes. Die erwähnten Rauschprobleme können einen einwandfreien Betrieb der mit den Ausgangstreibern versehenen Schaltungen beeinträchtigen.

Bisher wurden diese Rauschprobleme nicht in befriedigender Weise beseitigt, da allenfalls versucht wurde, die Versorgungsspannungen der MOS-Ausgangstreiber von den Versorgungsnetzen der benachbarten Bauelemente entfernt zu halten.

Es ist daher Aufgabe der vorliegenden Erfindung, einen MOS-Ausgangstreiber zu schaffen, der nur eine kleine kapazitive Kopplung zum Substrat zeigt.

Diese Aufgabe wird bei einem MOS-Ausgangstreiber der eingangs genannten Art erfindungsgemäß dadurch gelöst, daß die Wanne von einer Abschirmschicht des einen Leitfähigkeitstyps umgeben ist. Die Wanne wird dabei in bevorzugter Weise mit einer hochdotierten Kontaktzone des anderen Leitfähigkeitstyps versehen, so daß eine gute Kontaktgabe zu der Wanne gewährleistet ist. Weiterhin können zwischen der Abschirmschicht und den Source- und Drainzonen bzw. der hochdotierten Kontaktzone Dickoxyde vorgesehen werden, die ebenfalls für eine nur geringe kapazitive Kopplung und damit für eine Verminderung von Rauschproblemen sorgen. Bei einer n-leitenden Abschirmschicht wird diese vorzugsweise mit einer positiven Vorspannung beaufschlagt.

Die Erfindung ist in vorteilhafter Weise bei Ausgangstreibern von CMOS-Schaltungen anwendbar und sorgt bei diesen für eine erhebliche Verminderung kapazitiver Kopplungen von den Ausgangstreibern in das Substrat.

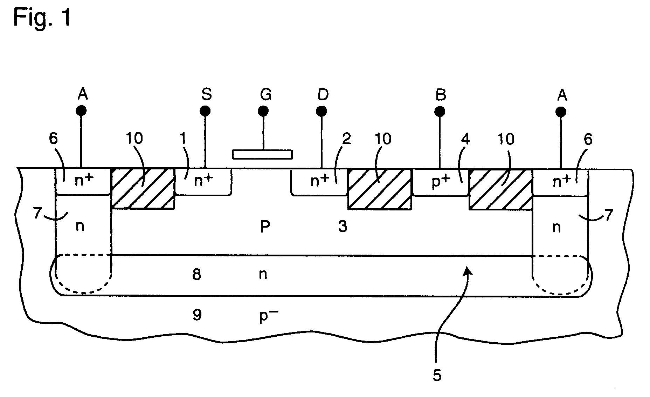

Nachfolgend wird die Erfindung anhand der Zeichnung näher erläutert, in deren einziger Figur ein MOS-Ausgangstreiber im Schnitt dargestellt ist.

In der Figur ist zunächst ein MOS-Transistor mit einer Sourceelektrode S, einer n⁺-leitenden Sourcezone 1, einer Gateelektrode G, einer Drainelektrode D und einer n⁺-leitenden Drainzone 2 gezeigt. Der Kanalbereich zwischen der Sourcezone 1 und der Drainzone 2 wird durch eine p-leitende Wanne 3 gebildet, die mit einer p⁺-leitenden Kontaktzone 4 mit einem Anschluß B versehen ist.

Diese Anordnung ist erfindungsgemäß durch eine Abschirmschicht 5 aus n⁺-leitenden Kontaktzonen 6, einem n-leitenden Diffusionsring 7 und einer n-leitenden Buried-Layer-Schicht 8 in einem p⁻-leitenden Halbleitersubstrat 9 umgeben. Die n⁺-leitenden Kontaktzonen 6 sind mit Anschlüssen A verbunden. Dickoxyd-Schichten 10 befinden sich jeweils zwischen der Kontaktzone 6 und der Sourcezone 1, zwischen der Drain-Zone 2 und der Kontaktzone 4 und zwischen der Kontaktzone 4 und der Kontaktzone 6.

An den Anschlüssen A liegt vorzugsweise eine positive Versorgungsspannung VDD, während der Sourceelektrode S und dem Anschluß B eine Spannung VSS zugeführt sein kann, wenn das Ausgangssignal an der Elektrode D abgegriffen wird.

Wesentlich an der vorliegenden Erfindung ist die Einbettung des MOS-Ausgangstreibers in die Abschirmschicht 5, also das Vorsehen einer zusätzlichen Isolationswanne, die die Wanne 3 umgibt und entgegengesetzt zu dieser dotiert ist. Auch tragen die Dickoxyd-Schichten 10 zur weiteren Entkopplung des Ausgangstreibers von dem Substrat bzw. von benachbarten Versorgungsnetzen bei.

## Patentansprüche

1. MOS-Ausgangstreiber mit in ein Halbleitersubstrat (9) eingebetteten Source- und Drainzonen (1, 2) des einen Leitfähigkeitstyps, die in einer Wanne (3) des anderen, zum einen Leitfähigkeitstyp entgegengesetzten Leitfähigkeitstyps voneinander beabstandet sind,
**dadurch gekennzeichnet**,
daß die Wanne (4) von einer Abschirmschicht (5; 6 bis 8) des einen Leitfähigkeitstyps umgeben ist.

2. MOS-Ausgangstreiber nach Anspruch 1,
**dadurch gekennzeichnet**,
daß die Wanne (3) mit einer hochdotierten Kontaktzone (4) des anderen Leitfähigkeitstyps versehen ist.

3. MOS-Ausgangstreiber nach Anspruch 1 oder 2,
**dadurch gekennzeichnet**,
daß zwischen der Abschirmschicht (5; 6 bis 8) und den Source- und Drainzonen (1, 2) bzw. der hochdotierten Kontaktzone (4) Dickoxyd-Schichten (10) vorgesehen sind.

4. MOS-Ausgangstreiber nach Anspruch 3,
**dadurch gekennzeichnet**,
daß bei n-leitender Abschirmschicht (5; 6 bis 8) diese mit positiver Vorspannung beaufschlagt ist.
